# EUROPEAN PATENT SPECIFICATION

(11) **EP 0 396 524 B1**
(45) Date of publication and mention of the grant of the patent: **03.01.1996**
(21) Application number: 90850155.4
(22) Date of filing: 24.04.1990
(51) Int. Cl.: H05K 3/00, B28D 5/00, H05K 1/02

(54) **A system and method for manufacture of micro-panels**
Vorrichtung und Verfahren zur Herstellung von Mikroplatten
Système et méthode pour la fabrication de microplaquettes

(30) Priority: 05.05.1989 US 347693
(43) Date of publication of application: 07.11.1990
(73) Proprietor: International Business Machines Corporation, Armonk, N.Y. 10504 (US)
(72) Inventor: Frankeny, Jerome Albert, Taylor, Texas 76574 (US); Frankeny, Richard Francis, Elgin, Texas 78621 (US); Hermann, Karl, Austin, Texas 78758 (US); Wustrau, Rolf, Austin, Texas 78731 (US)
(74) Representative: Burt, Roger James, Dr.

(56) References cited:
- DE-A- 2 306 842
- DE-A- 3 137 301
- DE-A- 3 806 984

## Description

### Techical Field

This invention relates to boards for use in production of micro-panels, and to the formation of micro-panels from a board for use in the manufacture of electronic assemblies .

### Background Art

In the manufacture of micro-panel boards of the multilayer type typically having two layers or sheets of conductive material separated by an insulator which are subsequently populated with various electronic components and circuitized to form an electronic circuit card, it is conventional to manufacture large boards which are then cut into smaller micro-panels in the desired sizes (see e.q. DE-A-2 306 842).

Typically the micro-panel will be of a square or rectangular configuration. Consequently a plurality of such panels will be produced from a board by various punching and cutting techniques well known in the art for forming such panels from the larger boards. However, one serious problem which has continued to be troublesome in manufacture of such micro-panels is that during the operation of punching out the panels or otherwise severing them from the board, frequently it has been found that the conductive material forming one of the conductive layers deforms or smears along the edge of the cut so as to effect electrical contact with the conductive material of the remaining layer, thereby shorting the two conductive layers together. Such shorting is highly undesirable inasmuch as it is conventional to provide electrical circuits on the two conductive layers which are intended to be electrically isolated from one another.

One solution to the problem has been to simply manufacture the micro-panels in the intended size in the first place to thereby circumvent the need to severe them from a larger board. This approach has obvious drawbacks in manufacturing efficiency in that it is much more effective to manufacture the raw boards in larger dimensional configurations and to thereafter form a plurality of panels from each such board.

Yet another attempt to solve the problem has been to provide for thicker insulative layers separating the conductive layers sandwiched thereabout or, in the alternative, to provide for much thinner metalization of the conductive layers. In this manner it was hoped that the aforementioned smearing of conductive material from one layer to the other could thereby be prevented by providing a larger physical separation between the conductive layers, in the case of the increased insulator thickness, or, alternatively, by providing less conductive material capable of being smeared around the edge of the cut in the board to thereby undesirably contact the remaining layer.

Both of the foregoing approaches have also been found unsatisfactory for several reasons. First, with the evolution of modern packaging technology and the need for more and more dense and multiple layer packages, increasing the insulator thickness has been found to be highly undesirable particularly when, for example, it may be desired to stack multiple micro-panels. It is also often been found that provision of thinner metalization layers to avoid the problem has been unacceptable as, for example, in the case wherein it is necessary to etch increasingly finer pitched circuit paths in the conductive layer.

Accordingly, a system and method was greatly needed in the industry for forming a plurality of micro-panels from raw boards which was both reliable and economical while at the same time avoiding the hereinbefore noted problems of conductive layer shorts during the manufacturing process.

### Summary of the Invention

The present invention is defined in the attached claims.

A multilayer board is comprised of upper and lower conductive layers with an insulative layer sandwiched therebetween. Geometric patterns are defined in the upper layer alternately by slots extending therethrough and material sections between the ends of adjacent slots. Identical geometric patterns are defined in the lower conductive layer in vertical registry with the upper patterns. Slots and material sections in the lower layer corresponding to material sections and slots of identical length and orientation vertically thereabove respectively in the upper section. All material sections in either the upper or lower layer therefore have a correlative slot therebelow or thereabove in vertical registry in the lower or upper layer, respectively. With respect to a given preselected pattern, by punching through the slots in the upper and lower layers partially defining the pattern and continuing therethrough to penetrate through the opposing correlative vertically aligned material section of the lower or upper layer, a micro-panel is thereby formed in the shape of the pattern upon severance from the board. Due to slot-material section configuration in the upper and lower layers so that no conductive material is directly in vertical alignment with a slot, upon severance of the micro-panel from the board conductive material of one layer is prevented from smearing and thereby shorting out to the other conductive layer along the edge of the panel.

### Brief Description of the Drawings

The novel features believed to be characteristic of the invention are set forth in the appended claims. The invention itself, however, as well as other features and advantages thereof, will be best understood by reference to the following description of the preferred embodiment, when read in conjunction with the accompanying figures, wherein:
Fig. 1 is a pictorial illustration of a raw board adapted in the manner of the present invention for formation of micro-panels;
Fig. 2 is a top plan view of the board of Fig. 1;
Fig. 3 is a pictorial view of the insulative layer of the board of Fig. 1;
Fig. 4 is a top plan view of the second conductive layer of the board of Fig. 1;
Fig. 5 is a top plan view of the conductive layers of Figs. 2 and 4 showing corner punch apertures prior to slots being disposed therein;
Fig. 6 is a pictorial illustration of a micro-panel of the present invention after being severed from the board of Fig. 1;
Fig. 7 is an enlarged pictorial view of the upper surface of the board of Fig. 1 depicting in greater detail the slots extending therethrough.

### Detailed Description of the Preferred Embodiment

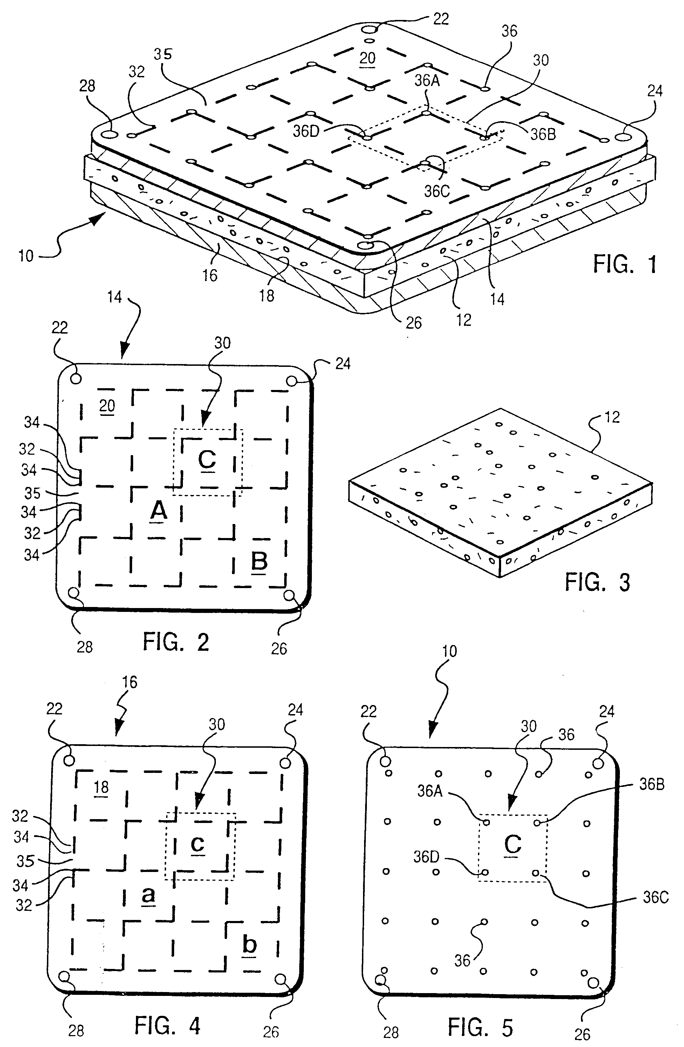

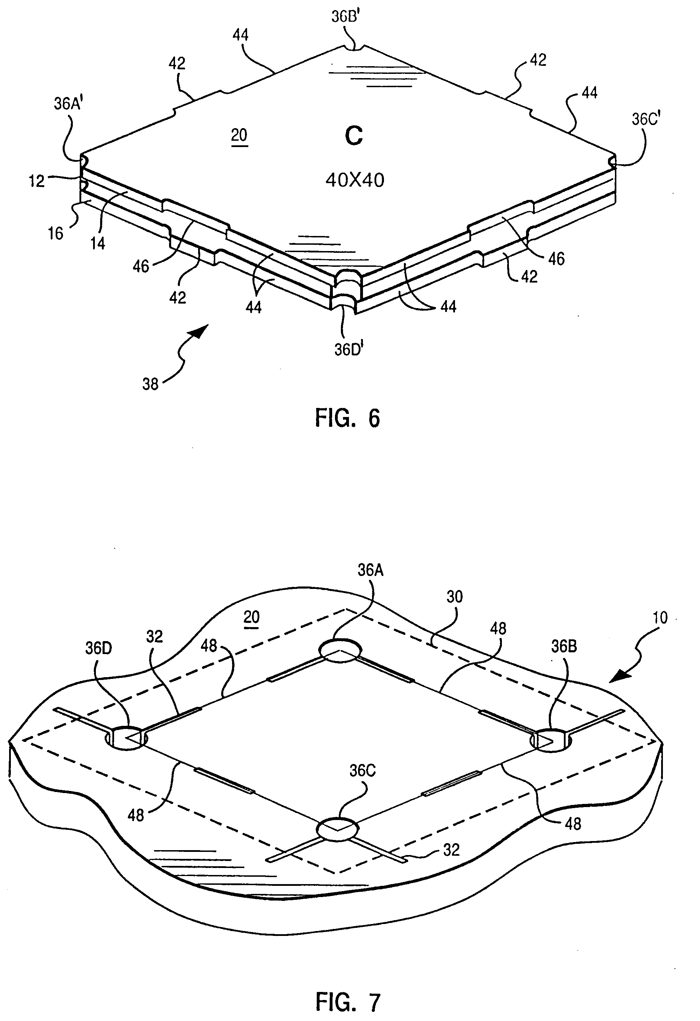

Referring first to Fig. 1, a raw board 10 is shown prior to severance in the manner of the invention to produce the severed micro-panels 38 shown in Fig. 6. The board 10 is comprised of an insulative sheet 12 having laminated on opposing sides thereof an upper conductive layer 14 and a lower conductive layer 16. For purposes of clarity the various layers 12-16 are shown, as in the case of the insulative layer 12 depicted in Fig. 3, as being comprised of a homogenous layer of one material however the invention is not intended to be so limited. Accordingly, with respect to the upper and lower layers 14 and 16 they may more conventionally each be comprised actually of a multi-layered layer themselves. For example, these conductive layers 14 and 16 are typically provided in the form of a copper layer followed by an invar layer and then a next copper layer for purposes of matching thermal expansions in a manner well known in the art.

Still referring to Fig. 1, as may be seen from the view of the upper surface 18 of the lower conductive layer 16 and the upper surface 20 of the upper conductive layer 14 in Figs. 2 and 4, respectively, a geometric pattern is formed therethrough by careful positioning of slots 32 extending through the layers and resultant material sections 35 therebetween as will be hereinafter described in greater detail. It will be recalled that it is conventional to manufacture such boards 10 in much larger dimensions than is required of the particular individual micro-panels 38. Accordingly, in contemplation of subsequent manufacturing operations (including the disposition of the slots through the conductive layers and the cutting, punching, and drilling operations to be described) a plurality of locating holes 22, 24, 26 and 28, Fig. 1, are preferably disposed in the outer periphery of the board 10. In this manner locating pins extending therethrough may hold the boards 10 in a preselected spatial orientation as required for the subsequent machining and other manufacturing operations.

For illustrative purposes only dotted lines 30 have been shown in Fig. 1 to clearly demarcate an illustrative portion of the board 10 comprising an unsevered micro-panel wherein after separating this section from the board 10 in the manner of the invention, the desired resultant severed micro-panel 38 of Fig. 6 is produced. It will further be noted with reference to Fig. 1 that in addition to the locator holes 22-28, a plurality of corner holes 36 are disposed at various locations through the board 10. These corner holes 36 are for purposes of assisting in the clean severance of panels 38 as desired. For example, corner holes 36a-36d are shown extending through the board 10 at the corners of the geometric pattern formed by the unsevered panel 30 to be thereafter separated from the board 10, such corner holes insuring a clean and smooth break of the severed panel 38 from the board 10 as well as providing locating as may be desired during punching or cutting operations to sever the board. As may be seen in Figs. 2 and 4 these corner holes in layer 14 are preferably of a different diameter than those of layer 16 in vertical registry therewith. This avoids smearing of conductive material at the holes to prevent shorting of layers 14-16 after severance of the panels 38 in like manner to the similar purpose of alternate vertically registered slots and material sections to prevent this smearing.

Referring now to Fig. 2, the upper layer 14 is shown. With respect to each slot 32 extending through the layer 14 or 16 slot ends 34 are defined. The term material section 35 refers to the material comprising the layer which extends in a line between adjacent slot ends 34 of adjacent slots 32 of a given layer. It will be noted from Fig. 2 that the sequentially alternating slots 32 and material sections 35 in combination define geometric patterns which in turn delineate areas such as a, b, and c in the conductive layers 14, 16. Upon severing the panel 38 from the board 10 it will be seen that each panel 38 will assume the general geometric shape of the area such as the squares a, b, c, formed by the patterns defined by the slots 32 and material sections 35. In the embodiment depicted in the figures, these areas a, b, c and patterns are in the form of squares of uniform size whereby upon severing the plurality of the panels 38 the panels will in turn be of substantially identical size and shape.

Whereas this is done for purposes of manufacturing efficiency, wherein the illustrative areas a, b, c and panels 38 are of the same geometric size and shape, the invention is not intended to be so limited. Accordingly, the slot 32 and material sections 35 in the upper and lower layers 14, 16 may be disposed so as to define a number of different geometric patterns and resultant areas if desired. Upon severing the panels 38 from the board 10, a number of differently shaped such panels may be created from the same board 10 conforming to the various different geometric patterns formed by the slots 32 and materials section 35 as required.

Referring now to Fig. 4, in like manner to that of Fig. 2, these slots 32 extending through lower layer 16 and material sections 35 will define identically dimensioned and spatially oriented geometric patterns and areas a, b, c in the lower layer 16. However, a careful comparison of the positioning of the slots 32 and material sections 35 in the upper layer 14, Fig. 2, relative to those in lower layers 16, Fig. 4, will reveal a subtle but nevertheless significant difference which is important to the invention. If it can be imagined for the moment that the upper layer 14 of Fig. 2 is superimposed on the lower layer 16 of Fig. 4 with the various slots 32 and material sections 35 disposed therein and with the locating holes 22-28 in vertical registry, it will be noted that each slot 32 in the upper and lower layers 14, 16 will have a correlative material section 35 disposed in vertical registry in the opposing lower and upper layer 16, 14, respectively. Moreover, the geometric area or shape a, b, c defined in each layer by its respective slots 32 and material sections 35 will be seen to be in vertical registry with correlative such geometric shapes or areas in the other layer when the layers are disposed together parallel to one another with the locator holes 22-28 in vertical registry as hereinbefore described. In other words, these areas in the upper and lower layers will be of necessity disposed in the same spatial orientation with respect to one another in vertical registry in the parallel planes in which these layers lie (the significance of which will become apparent from a more detailed description of subsequent manufacturing operations and the panel embodiment of Fig. 6 which will hereinafter follow).

In Fig. 5 the holes 36 may be seen in the layers 14, 16 without the slots 32 for purposes of clarity in indicating that the holes 36 are preferably disposed through the board 10 at locations where slots 32 intersect for the aforementioned purpose of facilitating clean punchout of panels 38 as desired. Thus, for example, it will be noted that holes 36a, 36b, 36c and 36d are disposed at corner locations of the geometric shape c of Figs. 2 and 4 so that when this unsevered panel 30 section of board 10 is severed to form the panel 38 these holes 36a-36d will facilitate such severance without smearing at the corners.

With reference to Fig. 6, there is depicted therein one of the severed panels 38 from the board 10 corresponding to the geometric area c. At the corners thereof partial holes 36a', 36b', 36c', and 36d' are recognized as being portions of the holes 36a-36d just described with reference to Fig. 5. In the punchout of the area c from the board 10 along the lines defined by the slots 32 defining the geometric shape of area c, this punching operation will extend through the holes 36a-36d whereby only portions of the board 10 defining one-quarter of the holes 36a-36d (as shown by 36a'-36d' of Fig. 6) remain.

Still referring to Fig. 6 yet an additional aspect of the invention may be seen depicted therein. Once the geometric patterns are defined in the upper and lower layers Fig. 2 and Fig. 4 by the slots 32 as previously described, and once the layers have been vertically aligned with the insulative layer 12 disposed therebetween, and further once the various holes have been drilled as required (preferred although not necessary), it is next desirable to shear or punch out panels 38 from the board 10 as desired. This punching operation may be accomplished by any of a number of techniques well known in the art wherein the board 10 is punched through along lines 48 (Fig. 7) bisecting the slots 32 which define geometrical area c. As a result of such die cutting, punching, or other operation, with a more detailed reference to Fig. 6, it will be noted that a plurality of protruding lips 42 will extend radially outwards from outer edges 44 of the upper and lower layers 14, 16.

In like manner, recesses 46 will be formed which extend radially inwards toward the center of the panel 38 along these outer edges 44 of the upper and lower layers 14, 16. Furthermore, each such protrusions 42 of a given layer will have a correlative recess 46 in vertical registry therewith. This formation of protrusions 42 and recesses 46 may be seen to be caused by the arrangement of slot 32-material section 35 pairs in vertical registry in the upper and lower layers 14, 16 as previously described with reference to Figs. 2 and 4. It is a feature of the invention that as the cutting or punching operation occurs (along the lines of the slots 32 of one layer defining the desired geometrical shape of the particular panel 38 and proceeds downwards or upwards through material sections 35 of the other layer in vertical registry) because material sections occurring in both layers 14 and 16 are not permitted to be in vertical registry there is no danger of conductive material from one of the layers smearing about the edge of the panel 38 so as to undesirably contact and thereby short out to the remaining conductive layer. It will be appreciated that the appearance of these protrusions 42 and recesses 46 may be made as small as desired and substantially non-existent if necessary for a given panel 38 by making the punches or cuts to the various slots 32 along the inner or outer edges defining the slots rather than by making the cuts or punches along the lines 48 of Fig. 7 which bifurcate the slots 32 thereby giving rise to the protrusions 42 and recesses 46.

However, the invention is not intended to be so limited to a particular manner of cutting along the slots 32 defining the desired geometric pattern of the resultant panel 38. A fundamental concept of the invention is to insure that conductive material is removed from one of the conductive layers at locations where conductive material will exist in the remaining layer in vertical registry along the lines locating the cuts to be made to severe the panel 38. This will thereby avoid, during the cutting or punching process, conductive material from one of the layers smearing about the outer peripheral edge of the panel so as to contact and short to conductive material in vertical registry therewith on the remaining layer.

## Claims

1. A board (10) for use in production of micro-panels employed in the manufacture of electronic assemblies, comprising
a first upper conductive layer (14) having alternating slots (32) and material portions (35) extending between adjacent slot ends, defining at least one geometric pattern (a,c), the slots extending through said layer;
a lower conductive layer (16) having alternating material portions (35) and slots (32) extending therethrough, defining at least one geometric pattern (a, c) substantially in vertical registry with said at least one pattern in said upper layer; and
an insulating layer (12) disposed between said upper and lower conductive layers;
wherein a given slot (32) in the upper layer is in vertical registry with a corresponding material portion (35) in the lower layer, and wherein a given slot (32) in the lower layer is in vertical registry with a corresponding material portion (35) in the upper layer.

2. A board according to claim 1 wherein each slot is in vertical registry with a corresponding material portion is of substantially equal length to said material portion.

3. A board according to claim 1 or claim 2, wherein said at least one geometric pattern comprises a plurality of said patterns (a,c,b).

4. A board according to claim 3 wherein said patterns are of equal size.

5. A board according to any of claims 1 to 4 wherein said patterns define a plurality of corners and wherein the upper and lower layers have a corresponding plurality of apertures (36) extending vertically through said board at said corners.

6. A board according to claim 5 wherein corresponding apertures in the upper and lower layers have different diameters.

7. A board according to any one of the preceding claims, wherein at least one of said upper and lower conductive layers or said insulating layer has a multilayered structure.

8. A micro-panel for use in production of electronic assemblies, which micro-panel is formed from a board according to any one of the preceding claims and comprises:
an upper conductive layer (14) having an outer peripheral edge (44), said outer edge defining a plurality of outwardly extending projections (42) and inwardly extending recesses (46);
a lower conductive layer (16) having an outer peripheral edge (44), said outer edge of the lower layer (16) defining a plurality of outwardly extending projections (42) and inwardly extending recesses (46); and
an insulative layer (12) disposed between said upper and lower conductive layers; wherein a given projection of the upper or lower conductive layer is in vertical registry with a recess of the respective other conductive layer.

9. A method for manufacturing a micro-panel from a board for use in production of electronic assemblies, comprising
defining a plurality of patterns (a,c) in an upper conductive layer (14) by forming slots (32) extending through said upper layer which slots have material portions (35) of the upper layer extending between their ends;
defining a plurality of patterns (a,c) in a lower conductive layer (16) by forming slots extending through said lower layer which slots have material portions (35) of the lower layer extending between their ends;
disposing an insulative layer (12) between the upper and lower layers, and aligning the layers to produce a board wherein the patterns in said lower conductive layer are substantially in vertical registry with the patterns in said upper conductive layer, such that a given slot in the upper layer is in vertical registry with a corresponding material portion in the lower layer, and a given slot in the lower layer is in vertical registry, with a corresponding material portion in the upper layer; and
severing a micro-panel (38) from the board by penetrating through the board along lines of the patterns defined by the slots.

10. A method according to claim 9 wherein said patterns define a plurality of corners, and wherein said method further comprises the step of forming a hole vertically through the upper and lower layers of the micro-panel at each corner.

11. A method according to claim 10 wherein said step of forming holes comprises forming holes in the upper layer; and forming holes in the lower layer in vertical registry with the upper layer holes, said lower layer holes each having a diameter different from a corresponding one of the upper layer holes in vertical registry therewith.

12. A method according to any one of claims 9 to 11 wherein the upper and lower slots and the upper and lower material portions therebetween which define one of the patterns further define a portion of at least one next adjacent pattern of the plurality of patterns.

## Patentansprüche

1. Eine Platine (10), aus der Mikroplatten hergestellt werden, die bei der Fertigung von elektronischen Baugruppen zum Einsatz kommen, und die folgendes umfaßt:
Eine erste obere leitende Schicht (14) mit abwechselnden Schlitzen (32) und zwischen benachbarten Schlitzenden verlaufenden Materialabschnitten (35), die mindestens eine geometrische Struktur (a,c) definieren, wobei die Schlitze durch diese Schicht hindurch verlaufen;
Eine untere leitende Schicht (16) mit abwechselnden Materialabschnitten (35) und durch sie hindurch verlaufenden Schlitzen (32), die mindestens eine geometrische Struktur (a,c) definieren und eine im wesentlichen vertikale Lagegenauigkeit mit mindestens einer Struktur in der oberen Schicht aufweisen; und
Eine Isolierschicht (12), die zwischen der oberen und unteren leitenden Schicht angeordnet ist;
Wobei sich ein bestimmter Schlitz (32) in der oberen Schicht in vertikaler Lagegenauigkeit mit einem entsprechenden Materialabschnitt (35) in der unteren Schicht befindet, und wobei sich ein bestimmter Schlitz (32) in der unteren Schicht in vertikaler Lagegenauigkeit mit einem entsprechenden Materialabschnitt (35) in der oberen Schicht befindet.

2. Eine Platine gemäß Patentanspruch 1, auf der sich jeder Schlitz in vertikaler Lagegenauigkeit mit einem entsprechenden Materialabschnitt befindet und im wesentlichen die gleiche Länge wie der Materialabschnitt aufweist.

3. Eine Platine gemäß Patentanspruch 1 oder 2, auf der mindestens eine der geometrischen Strukturen eine Vielzahl solcher Strukturen (a, c, b) umfaßt.

4. Eine Platine gemäß Patentanspruch 3, auf der die Strukturen die gleiche Größe aufweisen.

5. Eine Platine gemäß einem beliebigen der Patentansprüche 1 bis 4, auf der die Strukturen eine Vielzahl von Ecken definieren und auf der die oberen und unteren Schichten an den Ecken eine entsprechende Vielzahl von öffnungen (36) aufweisen, die vertikal durch die Platine hindurch verlaufen.

6. Eine Platine gemäß Patentanspruch 5, auf der die entsprechenden öffnungen in der oberen und unteren Schicht unterschiedliche Durchmesser aufweisen.

7. Eine Platine gemäß einem beliebigen der vorstehenden Ansprüche, auf der mindestens eine der oberen und unteren leitenden Schichten oder der Isolierschicht eine Mehrlagenstruktur aufweist.

8. Eine in der Herstellung von elektronischen Baugruppen verwendete Mikroplatte, wobei diese Mikroplatte aus einer Platine gemäß einem beliebigen der vorstehenden Patentansprüche hergestellt wird und folgendes umfaßt:
Eine obere leitende Schicht (14) mit einer äußeren peripheren Kante (44), wobei diese äußere Kante eine Vielzahl von nach außen gerichteten Vorsprüngen (42) und nach innen gerichteten Aussparungen (46) definiert;
Eine untere leitende Schicht (16) mit einer äußeren peripheren Kante (44), wobei diese äußere Kante der unteren Schicht (16) eine Vielzahl von nach außen gerichteten Vorsprüngen (42) und nach innen gerichteten Aussparungen (46) definiert; und
Eine Isolierschicht (12), die zwischen den oberen und unteren leitenden Schichten angeordnet ist; wobei sich ein bestimmter Vorsprung der oberen oder unteren leitenden Schicht in vertikaler Lagegenauigkeit mit einer Aussparung der entsprechenden anderen leitenden Schicht befindet.

9. Ein Verfahren zur Herstellung einer Mikroplatte aus einer Platine für die Herstellung von elektronischen Baugruppen, das folgendes umfaßt:
Definition einer Vielzahl von Strukturen (a, c) in einer oberen leitenden Schicht (14) durch die Bildung von Schlitzen (32), die durch die obere Schicht hindurch verlaufen, wobei die Schlitze Materialabschnitte (35) in der oberen Schicht aufweisen, die zwischen ihren Enden verlaufen.
Definition einer Vielzahl von Strukturen (a, c) in einer unteren leitenden Schicht (10) durch Bildung von Schlitzen, die durch die untere Schicht hindurch verlaufen, wobei die Schlitze zwischen ihren Enden verlaufende Materialabschnitte (35) in der unteren Schicht aufweisen.
Anordnen einer Isolierschicht (12) zwischen den oberen und unteren Schichten und Ausrichten der Schichten zwecks Herstellung einer Platine, auf der sich die Strukturen in der unteren leitenden Schicht im wesentlichen in vertikaler Lagegenauigkeit mit den Strukturen in der oberen leitenden Schicht befinden, so daß sich ein bestimmter Schlitz in der oberen Schicht in vertikaler Lagegenauigkeit mit einem entsprechenden Materialabschnitt in der unteren Schicht befindet, und ein bestimmter Schlitz in der unteren Schicht in vertikaler Lagegenauigkeit mit einem entsprechenden Materialabschnitt in der oberen Schicht befindet; und
Abtrennen einer Mikroplatte (38) von der Platine, indem die Platine entlang den Linien der Strukturen abgetrennt wird, die durch die Schlitze definiert werden.

10. Ein Verfahren gemäß Patentanspruch 9, bei dem die Strukturen eine Vielzahl von Ecken definieren, und wobei das Verfahren weiterhin den Schritt der Bildung eines Loches umfaßt, das vertikal durch die oberen und unteren Schichten der Mikroplatte an jeder Ecke verläuft.

11. Ein Verfahren gemäß Patentanspruch 10, bei dem:
Der Schritt der Bildung von Löchern die Bildung von Löchern in der oberen Schicht und die Bildung von Löchern in der unteren Schicht umfaßt, die sich in vertikaler Lagegenauigkeit mit den Löchern in der oberen Schicht befinden, wobei die Löcher in der unteren Schicht jeweils einen Durchmesser aufweisen, der von einem entsprechenden Durchmesser in den Löchern der oberen Schicht abweicht, mit denen sie sich in vertikaler Lagegenauigkeit befinden.

12. Ein Verfahren gemäß einem beliebigen der Patentansprüche 9 bis 11, bei dem die oberen und unteren Schlitze sowie die dazwischen befindlichen oberen und unteren Materialabschnitte weiterhin einen Abschnitt von mindestens einer nächsten angrenzenden Struktur aus der Vielzahl von Strukturen definieren.

## Revendications

1. Une plaque (10) pour utilisation dans la production de micro-plaquettes, utilisées dans la fabrication d'ensembles électroniques, comprenant :
une première couche supérieure (14) conductrice, présentant une alternance de fentes (32) et de parties de matière (35) s'étendant entre les extrémités de fentes adjacentes, définissant au moins un motif géométrique (a, c), les fentes s'étendant dans ladite couche;
une couche conductrice inférieure (16) ayant une alternance de parties de matière (35) et de fentes (32) s'étendant à travers elles, définissant au moins un motif géométrique (a, c) sensiblement en concordance verticale avec au moins un motif réalisé dans ladite couche supérieure; et
une couche isolante (12) disposée entre lesdites couches conductrices supérieure et inférieure;
dans laquelle une fente (32) donnée, située dans la couche supérieure, est en concordance verticale avec une partie matière (35) correspondante se trouvant dans la couche inférieure et dans laquelle une fente (32) donnée se trouvant dans la couche inférieure est en concordance verticale avec une partie matière (35) correspondante se trouvant dans la couche supérieure.

2. Une plaque selon la revendication 1, dans laquelle chaque fente est en concordance verticale avec une partie matière correspondante de longueur sensiblement égale à ladite partie matière.

3. Plaque selon la revendication 1 ou la revendication 2, dans laquelle ledit au moins un motif géométrique comprend une pluralité dedits motifs (a, c, b).

4. Plaque selon la revendication 3, dans laquelle lesdits motifs sont de même taille.

5. Plaque selon l'une quelconque des revendications 1 à 4, dans laquelle lesdits motifs définissent une pluralité d'angles et dans laquelle les couches supérieure et inférieure ont une pluralité correspondante d'ouvertures (36) s'étendant verticalement dans ladite plaque, auxdits angles.

6. Plaque selon la revendication 5, dans laquelle des ouvertures correspondantes, ménagées dans les couches supérieure et inférieure, ont des diamètres différents.

7. Plaque selon l'une quelconque des revendications précédentes, dans laquelle au moins l'une desdites couches conductrices supérieure et inférieure ou ladite couche isolante ont une structure multicouche.

8. Micro-plaquette pour utilisation dans la production d'ensembles électroniques, ladite micro-plaquette étant formée à partir d'une plaque selon l'une quelconque des revendications précédentes et comprenant :
une couche conductrice supérieure (14) ayant un bord périphérique extérieur (44), ledit bord extérieur définissant une pluralité de saillies (42) s'étendant vers l'extérieur et de cavités (46) s'étendant vers l'intérieur;
une couche conductrice inférieure (16) ayant un bord périphérique extérieur (44), ledit bord extérieur de ladite couche inférieure (16) définissant une pluralité de saillies (42) s'étendant vers l'extérieur et de cavités (46) s'étendant vers l'intérieur; et
une couche isolante (12) disposée entre lesdites couches conductrices supérieure et inférieure; dans laquelle une saillie donnée de ladite couche conductrice supérieure ou inférieure est en concordance verticale avec une cavité de la deuxième couche conductrice respective.

9. Procédé de fabrication d'une micro-plaquette à partir d'une plaque, pour utilisation dans la production d'ensembles électroniques, comprenant :
la définition d'une pluralité de motifs (a, c) dans une couche conductrice supérieure (14), formant des fentes (32) s'étendant dans ladite couche supérieure avec des fentes ayant des parties de matière (35) de la couche supérieure s'étendant entre leurs extrémités;
la définition d'une pluralité de motifs (a, c) dans une couche conductrice inférieure (16) formant des fentes s'étendant dans ladite couche inférieure, ces fentes ayant des parties de matière (35) de la couche inférieure s'étendant entre leurs extrémités;
la disposition d'une couche isolante (12), entre les couches supérieure et inférieure et l'alignement des couches afin de produire une plaque, dans lequel les motifs réalisés dans ladite couche conductrice inférieure sont sensiblement en concordance verticale avec les motifs réalisés dans ladite couche conductrice supérieure, de manière à ce qu'une fente donnée réalisée dans la couche supérieure soit en concordance verticale avec une partie de matière correspondante dans la couche inférieure et une fente donnée ménagée dans la couche inférieure soit en concordance verticale avec une partie de matière correspondante dans la couche supérieure; et
séparation d'une micro-plaquette (38) à partir de la plaque, par pénétration dans la plaque suivant des lignes du motif défini par les fentes.

10. Procédé selon la revendication 9, dans lequel lesdits motifs définissent une pluralité d'angles, et dans lequel ledit procédé comprend en outre l'étape de formation d'un trou verticalement, dans les couches supérieure et inférieure de la micro-plaquette, à chaque angle.

11. Procédé selon la revendication 10, dans lequel ladite table de formation de trous comprend :
la formation de trous dans la couche supérieure; et
la formation de trous dans la couche inférieure, en concordance verticale avec les trous de couche supérieure, lesdits trous de couche inférieure ayant chacun un diamètre différent du diamètre correspondant des trous de couche supérieure placés en concordance verticale avec eux.

12. Procédé selon l'une quelconque des revendications 9 à 11, dans lequel les fentes supérieure et inférieure et les parties de matière supérieure et inférieure se trouvant entre elles, qui définissent l'un des motifs, définissent en outre une partie d'au moins un motif adjacent venant ensuite parmi la pluralité de motifs.
